# EUROPEAN PATENT APPLICATION

(11) **EP 1 069 422 A1**
(43) Date of publication of application: **17.01.2001**
(21) Application number: 00115349.3
(22) Date of filing: 14.07.2000
(51) Int. Cl.: G01M 17/007

(54) **A remote diagnistic system for motor vehicles**

(30) Priority: 16.07.1999 DE 19933334
(71) Applicant: IVECO MAGIRUS AG, D-89079 Ulm (DE)
(72) Inventor: Hiermann, Ulrich, 89551 Königsbronn (DE)
(74) Representative: Eccetto, Mauro

(57) **Abstract**

The invention relates to a remote diagnostic system (10) for motor vehicles (16) with a local diagnostic unit (12) and a remote diagnostic unit (14). The local diagnostic unit (12) comprises control units (18) which are attached to operating devices (26) of the motor vehicle (16) and sensors for the determination of status data, a first central processor (22) which is connected with the control units (18) for the receipt of status data as well as a first communications interface (24) which is connected with the first central processor (22) for the exchange of data. The remote diagnostic system (14) comprises a second central processor (34), a user interface (40) which is connected with the same and a second communications interface (38) which is connected with the second central processor (34). The two communications interfaces (24, 38) are in connection for remote data transmission. The entire arrangement is connected in such a way that access to the status data is enabled to an operator (46) and the transmission of commands to the first central processor (22) is enabled. The control units (18) are connected with the first central processor (22) for receiving commands from the same, which commands are transmitted from the user interface (40) to the first central processor (22) for the manipulation of the status parameters of the operating devices (26).

## Description

The invention relates to a remote diagnostic system for motor vehicles in accordance with the preamble of the main claim.

Such remote diagnostic systems are particularly useful for modern trucks which are equipped with a plurality of electronic sensors and control units for the measurement or control of certain status parameters. They can concern devices for engine or gear control, anti-skid systems, electronically controlled suspensions, immobilizers, vehicle computers or the like. Control units for the control or monitoring of the pneumatic system of the vehicle can also be provided.

During the occurrence of a malfunction it is frequently mandatory due to the high complexity of these systems that a repair must be performed by a specialized expert. Such an expert is frequently not available on site. A car mechanic with average expert knowledge is riot capable of treating the very specific systems of a certain vehicle model. Moreover, certain electronic devices are frequently required for diagnosis and repair, which devices are also frequently not available on site.

The remote diagnostic unit in accordance with the subject matter of the invention allows performing a diagnosis of malfunctioning equipment from a remote location. For this purpose data are exchanged between a local diagnostic unit on the vehicle and a remote diagnostic unit located far away. In detail, the status data of the vehicle are transmitted in the local diagnostic unit to a central processor which is connecrted to a first communications interface. The same will transfer the data to a second communications interface of the remote diagnostic unit which sends the data to a second central processor. In this way a remote data transmission between the two diagnostic units is enabled. Apart from the transmission of the status data to the central processor of the remote diagnostic unit it is conversely possible to transmit commands for data scanning for example to the central processor of the local diagnostic unit.

The data can be checked and evaluated by an operator via a user interface of the remote diagnostic unit which can comprise a monitor and a keyboard. A substantial control of the diagnosis is possible by entering respective commands.

The remote diagnostic unit can be located at a central place from where a single specialist or a group thereof can inspect individual operating equipment of the vehicle and provide advice to a mechanic or the vehicle's driver on site. For this purpose it is necessary to have communications with the involved persons via radio, mobile phone or a comparable means. A single central remote diagnostic unit is sufficent to provide coverage for a large number of vehicles, so that large savings in cost and time are achieved. In order to operate the local diagnostic unit it is not necessary that the operator needs any special knowledge of the vehicle's equipment or the remote diagnostic system per se.

The diagnostic module or a locally applied central processor only allows the selection and scanning of status data of the sensors and control units, however. It is frequently necessary however not only to start up the vehicle during the diagnosis but also to change certain status parameters such as the engine speed or the state of clutch or brakes in order to inspect status data depending on said operating states and to draw conclusions on existing faults.

For this purpose it is mandatory that the local operator operates the vehicle in a respective manner and coordinates the inspection with the experts at the control center. The entire diagnostic process becomes relatively intricate as a result of the coordination.

It is the object of the present invention to provide a remote diagnostic system for motor vehicles in which the cooperation between experts which operate the remote diagnostic unit and an on-site operator can be substantially omitted, so that the remote diagnosis can be performed substantially independently by the experts.

This object is achieved in accordance with the invention by the characterizing part of the main claim.

In a remote diagnostic system in accordance with the invention, the local central processor per se is not only provided to receive and select status data of the vehicle, but it is also possible to send control commands to the control units to change certain status parameters. These commands can come from the user interface and can be transmitted from the same to the central processor of the local diagnostic unit. Such a control from the remote diagnostic unit allows a direct access to the status parameters of the vehicle, so that its operation can be controlled substantially from the remote diagnostic unit. This direct possibility for access is not provided in known remote diagnostic units.

If it is desirable, for example, to change the speed of the running engine, the expert at the control center can enter a respective commend via the user interface into the central processor of the remote diagnostic unit, so that the command is received by the local central processor via the communcations interfaces and is forwarded to the respective control unit. In this way it is no longer necessary that an operator manipulates the vehicle in a respective manner on site, i.e. pressing the accelerator in this case, and performs respective coordinations with the expert at the control center. Apart from the preparations for the diagnostic process, the intervention of an operator on site is hardly or no longer required.

Various embodiments are possible for the local diagnostic unit. In a first preferred embodiment the entire local diagnostic unit is fixedly housed in the vehicle and is activated when needed. It may be appropriate under certain circumstances to attach the local central processor and the respective communications interface outside of the vehicle in accordance with a further preferred embodiment of the invention, with the connections between the control units and the central processor being detachable. In this manner it is possible to install the most important components of the local diagnostic unit in a car repair shop for example which as a result of the arrangement in accordance with the invention is in connection with the remote diagnostic unit at a control center. The defective vehicle can thus be brought for repairs to a respectively equipped workshop which is comparably close by.

In accordance with said second embodiment it is further preferably possible to provide the local central processor and the communications interface in a service vehicle which is driven towards the defective vehicle if required. This is particularly advantageous in cases where the vehicle is no longer operational and would have to be towed to a workshop.

Preferably, at least one of the central processors is equipped with optical and/or acoustic input and output units. These are necessary in order to provide the expert in the control center with additional information by viewing a defective part for example or listening to the sound of the engine.

If both central processors are equipped with such input and output units, the expert in the control center and the operator can communicate with one another. In this case an independent communications channel such as a radio link by additional radio sets is no longer required.

In a further preferred embodiment it is possible to feed or update operating programs into the control unit via the central processor. This proves to be advantageous for permanent changes to be made to status parameters. It may be desirable for example to change the ignition point of the engine by changing the program of the electronic system of the engine or to generally adapt the vehicle to changed working conditions such as a altered radiator control or bodywork manufacturer interface.

Preferably, the sensors of the control unit are provided not only for determining the status data of the vehicle, but also for measuring relevant environmental data of said equipment. This can prove to be useful when certain status parameters are dependent on environmental influences such as humidity, temperature, etc. Said additional information are transmitted to the expert in the control center, so that a more comprehensive picture of the situation is obtained and the diagnosis can be performed more reliably.

It is to be expected that in future vehicles will be equipped with an electronic display as a standard. It should be linked to the communications system in accordance with the invention.

Preferred embodiments are explained below by reference to the enclosed drawings, wherein:
- Fig. 1: shows the schematic arrangement of a remote diagnostic system in accordance with the invention.
- Fig. 2: shows the schematic arrangement of a second embodiment of a remote diagnostic system in accordance with the invention.

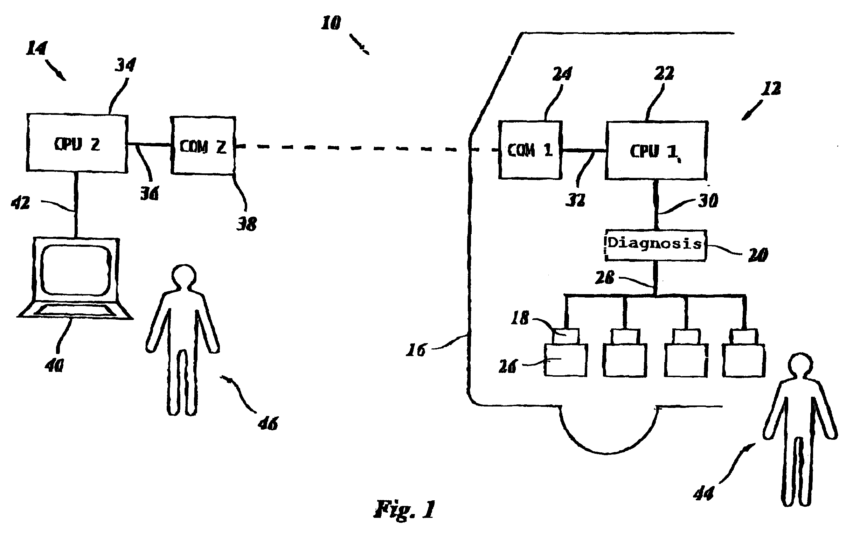

The remote diagnostic system as shown in fig. 1 is designated in its entirety with reference numeral 10 and comprises two components, namely a local diagnostic unit 12 and a remote diagnostic unit 14. The local diagnostic unit 12 is arranged completely within a motor vehicle 16 such as a truck for example. It comprises a plurality of control units 18, a diagnostic module 20 (marked in fig. 1 with "diagnosis"), a first central processor 22 marked with "CPU 1" and a first communications interface 24 marked with "COM 1".

The control devices 18 can be provided on the one hand for controlling operating functions of individual operating devices 26 of the vehicle, but comprise on the other hand sensors devices (not shown in detail) for determining status data of the vehicle. The reference numeral 26 stands principally for all elements of the vehicle which are equipped with electronic controls such as the engine, the gear, the brake, the immobilizer, etc. The respective control units 18 are connected with the diagnostic module 20 via a data line 28. The suitable allocation is performed with the help of the associated software. The diagnostic module 20 is connected on its part with the first central processor 22 via a further data line 30. A further data line 32 is used for connecting the first central processor 22 with the first communciations interface 24.

The remote diagnostic unit 14 is installed at a relatively large distance from the local diagnostic unit 12 and comprises a second central processor 34 which is marked with "CPU 2" and is connected via a data line 36 with a second communications interface 38 ("COM 2"), as well as a user interface 40 which on its part is also connected with the second central processor 34 via a data line 42. The user interface 40 substantially concerns an input and output unit comprising a monitor and a keyboard.

To operate the local diagnostic unit 12 there is provided a local operator 44 such as a car mechanic or the driver of the vehicle 16, whereas the remote diagnostic unit 14 is operated by a remote operator 46 such as a specialist for the operating unit 26 to be diagnosed.

During the diagnosis the control unit 18 transmits status data via data line 28 to the diagnostic module 20 which is used substantially for the coordination and preliminary processing of the data of the control units 18. The diagnostic module 20 can produce an error signal for example by performing a respective interpretation of the status data. These data are transmitted via a data line 30 to the first central processor 22 following a respective request from the same and are processed there.

The two communications interfaces 24, 38 are mutually connected in a wireless manner by way of radio, a satellite link or the like, so that a remote data transmission is possible between the two central processors 22, 34 as a result of the arrangement of the two central processors 22, 34 and the two communications interfaces 24, 38. This remote data connection is indicated schematically by a broken line. In particular, the status data can be read into the second central processor 34. The data can be further processed and inspected there. This process allows the remote operator 46 at the user interface 40 to directly inspect the diagnostic data of the control unit 18 or the diagnostic module 20.

To select the desired status data or the respective control unit 18, the remote operator 46 can enter the scanning commands via the user interface 40 into the second central processor 34, from where the commands reach the first central processor 22 via the described remote data transmission and further the diagnostic module 20 and from where the respective status data which enter the diagnostic module 20 are selected.

In accordance with the invention it is further possible to enter commands for changing status parameters in the same way via the user interface 40, which commands are transmitted via the communciations interfaces 38, 24 from the second central processor 34 to the first central processor 22 and reach the control units 18 via the diagnostic module 20. If the first central processor 22 is provided with a respective design, the control of the control units 18 by the central processor 22 can also occur directly via a data line in a manner not shown in fig. 1 without having to take the path via the diagnostic module 20.

For example, it may become necessary during the diagnosis to change the engine speed. The remote operator 46 enters a respective command into the user interface 40 for this purpose, which command reaches the control unit 18 of engine 26 of the motor vehicle 16 and causes the control unit 18 to change the engine speed as desired. It is thus not necessary that the local operator 44 presses the accelerator of the motor vehicle 16 for example.

Morever, the control unit 18 can be provided to store an operating program for the control of the engine. Said operating program can be changed in such a way that an operating program stored in the second central processor 34 is sent in the described manner to the first central processor 22 and thereafter to control unit 18 and is stored in the same.

It is possible that further sensors units (not shown) can be provided which are capable of measuring environmental. data such as humidity or heat and are connected in the same manner with the diagnostic module 20 as control unit 18. Furthermore, control units are possible for pneumatic systems of a truck which can be read out, controlled and changed in the aforementioned manner.

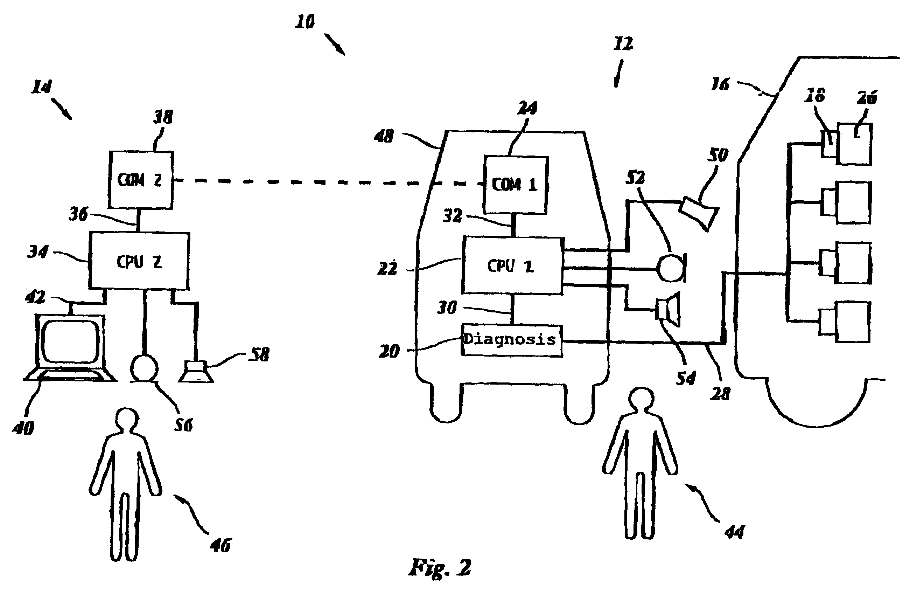

Fig. 2 shows a further embodiment of the invention in which the parts already described are provided with the same reference numerals as in fig. 1.

The remote diagnostic system 10 as exhibited in fig. 2 also comprises two diagnostic units, namely a local diagnostic unit 12 and a remote diagnostic unit 14. The local diagnostic unit 12 comprises in the known manner an exemplary exhibited control unit 18, a diagnostic module 20, a first central processor 22 and a first communications interface 24 which are mutually connected via respective data lines 28, 30, 32. Accordingly, the remote diagnostic unit 14 comprises a second central processor 34, a second communications interface 38 and a user interface 40 which are mutually connected via data lines 36, 42.

In contrast to fig. 1, the local diagnostic unit 12 is not arranged entirely within the motor vehicle 16, but merely the control unit 18 on engine 26. The other components are located within a maintenance vehicle 48 end the data line 28 for connecting the control unit 18 with the diagnostic module 20 is detachable. The connection is only produced for the duration of the diagnostic process. The service vehicle 48 is parked for this purpose in the ultimate vicinity of the motor vehicle 16 to be inspected. The mode of operation of the entire arrangement has already been described in closer detail in connection with fig. 1, so that any further description thereof shall be omitted for the purpose of brevity of the description.

As compared with the first embodiment, additional components are connected both with the first central processor 22 as well as with the second remote central processor 34. They concern optical and/or acoustic input and output units, namely a video camera 50, a microphone 52 and a loudspeaker 54 on the first central processor 22 as well as a second microphone 56 and a second loudspeaker 58 on the second central processor 34. Said input and output units 50, ..., 58 are connected in a comparable manner as the user interface 40 with the respective central processors 22, 34. Interfaces, digitizing devices or the like which are provided in the known manner anyway are not shown for the sake of simplicity of the illustration.

A direct optical and acoustic connection of the local diagnostic unit 12 with the remote diagnostic unit 14 is created by said units 50, ..., 58 in addition to the already described data connection, with said optical and acoustic connection being used on the one hand to transmit additional information on the operating state of the motor vehicle 16 and on the other hand to allow communications between the operators 44, 46. In this way the remote operator 46 can acoustically and visually inspect the operating device to be diagnosed, thus obtaining a more comprehensive picture of the situation. Moreover, the expert 46 can give the operator 44 instructions and receive feedback from the same.

## Claims

1. A remote diagnostic system (10) for motor vehicles (16), with a local diagnostic unit (12) and a remote diagnostic unit (14),
with the local diagnostic unit (12) comprising:
- a number of control units (18) which are attached to the operating devices (26) of the motor vehicle (16) and comprise sensors for the determination of status data;
- a first central processor (22) which for the receipt of status data is connected with the control units (18) either directly or via a diagnostic module (20);
- a first communications interface (24) which is connected for data exchange with the first central processor (22);
and with the remote diagnostic unit (14) comprising:
- a second central processor (34);
- a user interface (40) which is connected for data exchange with the second central processor (34) and can be operated by an operator (46);
- and a second communications interface (38) which is connected for data exchange with the second central processor (34);
which first and second communications interfaces (24, 38) are available for the remote transmission of data via a communications channel,
with the arrangement of the two central processors (22, 34) and the two communications interfaces (24, 38) being connected in such a way that the operator (46) has access to the status data via the user interface (40) and the transmission of commands to the first central processor (22) is enabled;
characterized in that the control units (18) are connected with the first central processor (22) for the receipt of commands therefrom, which commands are transmitted from the user interface (40) to the first central processor (22) for the manipulation of the status parameters of the operating devices (26).

2. The remote diagnostic system as claimed in claim 1, characterized in that the local diagnostic unit (12) is installed fixedly in the motor vehicle (16) or is transportable.

3. The remote diagnostic system as claimed in claim 1, characterized in that the first central processor (22) and the first communications interface (24) are attached outside of the vehicle (16) and the connection between the control units (18) and the first central processor (22) is detachable.

4. The remote diagnostic system as claimed in claim 3, characterized in that the first central processor (22) and the first communications interface (24) are installed in a service vehicle (46).

5. The remote diagnostic system as claimed in one of the preceding claims, characterized in that the first and second central processor (22, 34) are connected with optical and/or acoustic input and output units (50, ..., 58) for the communication of a local (44) and a remote operator (46) who each operate either the local or remote diagnostic unit (12, 14).

6. The remote diagnostic system as claimed in one of the preceding claims, characterized in that the central processor (22) is provided for feeding operating programs to the control units (18).

7. The remote diagnostic system as claimed in one of the preceding claims, characterized in that the control units (18) comprise sensors for determining environmental data of the operating devices (26) of the motor vehicle (16).
